(19) Europäisches Patentamt
European Patent Office
Office européen des brevets

(11) **EP 2 863 541 B1**

(12) **FASCICULE DE BREVET EUROPEEN**

(45) Date de publication et mention
de la délivrance du brevet:
**16.05.2018 Bulletin 2018/20**

(51) Int Cl.:
*H03F 1/32* (2006.01)　　　*H03G 3/30* (2006.01)
*H03F 3/24* (2006.01)　　　*H03G 1/04* (2006.01)

(21) Numéro de dépôt: **14189077.2**

(22) Date de dépôt: **15.10.2014**

(54) **Système et procédé d'amplification d'un signal**

System und Verfahren zur Verstärkung eines Signals

System and method for amplifying a signal

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.10.2013 FR 1302416**

(43) Date de publication de la demande:
**22.04.2015 Bulletin 2015/17**

(73) Titulaire: **THALES**
**92400 Courbevoie (FR)**

(72) Inventeurs:
 • **Bouvier, Jessica**
 **92622 GENNEVILLIERS CEDEX (FR)**

 • **Costa, Bruno**
 **92622 GENNEVILLIERS CEDEX (FR)**
 • **Guern, Pierre**
 **49309 Cholet (FR)**

(74) Mandataire: **Priori, Enrico**
**Marks & Clerk France**
**Conseils en Propriété Industrielle**
**Immeuble «Visium»**
**22, avenue Aristide Briand**
**94117 Arcueil Cedex (FR)**

(56) Documents cités:
**GB-A- 2 394 374　　US-A1- 2002 171 484**
**US-A1- 2010 248 658　　US-B1- 7 058 369**
**US-B2- 7 353 006**

**Description**

La présente invention concerne un système d'amplification possédant un dispositif d'asservissement de la puissance d'émission. Ces systèmes sont par exemple utilisables dans des équipements de radiocommunication civile ou militaire, utilisant des formes d'ondes à enveloppe non constante qui peuvent être mono-porteuse ou multi-porteuses.

Il est connu que l'utilisation de ce type de formes d'onde impose de prendre une marge sur la puissance de sortie de l'amplificateur de puissance (cette marge est également connue sous l'expression anglaise de Output Back-Off). Le but de cette marge est de rester dans une zone de fonctionnement linéaire de l'amplificateur de puissance. Cependant la présence de cette marge est antinomique de la recherche du meilleur rendement possible. En effet, afin d'améliorer le rendement des transistors de puissance utilisés dans les équipements de radiocommunication, ceux-ci sont souvent polarisés en classe AB. L'une des particularités de la classe AB est que son rendement augmente lorsque la puissance émise augmente. Une autre particularité de cette classe de fonctionnement est que son point de fonctionnement optimum en linéarité est dépendant d'un certain nombre de variables de fonctionnement tel que la fréquence d'émission utilisée ou la température. Ces particularités rendent nécessaire la recherche de compromis entre rendement et linéarité pour chaque forme d'onde.

Afin de résoudre cette problématique il est connu dans l'état de la technique des dispositifs qui comportent une boucle de contrôle automatique de puissance (également connue sous l'expression anglaise de ALC pour Automatic Level Control).

Il est connu dans l'état de la technique des systèmes qui utilisent un asservissement en boucle ouverte à partir de table de conversion. Cette table est réalisée en usine, durant la production de la radio et peut comporter éventuellement un mécanisme de mise à jour. Ainsi dans ces systèmes le contrôle de la puissance d'émission ne va pas dépendre du signal en sortie de l'amplificateur, mais uniquement du signal en entrée de l'amplificateur. Ces systèmes sont très sensibles à la variation de charge de l'antenne en situation de mobilité et imposent des temps de calibration importants, diminuant les capacités de productions des modules.

Il est aussi connu dans l'état de la technique des systèmes fonctionnant en boucle fermée, tels que la demande de brevet US 2002/0171484 A1 ou le brevet US7058369 B1. Ces systèmes sont présentés sur la figure 1, sont reliés à un modem 101 et comportent un dispositif 102 d'amplification présentant un gain d'amplification variable. Ils comportent aussi un dispositif 103 de détermination d'une différence entre le signal amplifié et une recopie du signal à amplifier. Enfin ces systèmes comportent un dispositif 104 de détermination du gain d'amplification à partir de la différence.

Il est connu que le dispositif 103 de détermination d'une différence effectue un filtrage du signal amplifié ou du signal représentant la différence afin d'enlever la contribution des variations de l'enveloppe de modulation sur le signal de commande de gain. La commande automatique de gain est alors fortement ralentie par rapport à la bande d'étalement des fréquences de la modulation utilisée. En général, la bande de boucle doit être cent fois inférieure à la bande passante de la modulation pour éliminer complètement les variations d'enveloppe. Ainsi les brevets US7023278 B1 (Rockwell Collins, 2006) et US6735420 B2 (Globespan Virata, 2001) présentent des systèmes utilisant cette solution. Ce type de système n'est donc pas utilisable pour l'amplification de signaux présentant des variations rapides de la fréquence de modulation (ces signaux sont aussi connus sous l'expression signaux EVF pour Evasion de Fréquence) et présentant une modulation dont l'enveloppe n'est pas constante. En effet ces systèmes font une différence entre un signal de consigne non modulé et un signal de retour modulé ce qui a pour effet de créer des perturbations sur le signal d'erreur se traduisant par une grande imprécision sur la commande du gain variable. En fonctionnement EVF ce système n'est pas acceptable car il n'a pas le temps de converger en un seul intervalle temporel d'émission du fait du filtrage devant être très important.

Il est connu que le dispositif 103 de détermination d'une différence utilise directement les échantillons du signal à amplifier comme consigne. Dans ce cas, la boucle de commande de gain peut être rapide et il est possible d'éliminer les variations d'enveloppe du signal de commande de gain. Ainsi les brevets US 7353006 B2 (Analog Devices, 2004) et US 7773691 B2 (RF Micro devices, 2005) présentent des systèmes qui utilisent cette solution. Dans ces systèmes il est possible d'éliminer les variations d'enveloppe sous réserve que le temps de propagation de groupe de la chaine d'émission ne soit pas trop important sinon cela se traduit également par une perturbation sur le signal d'erreur et une imprécision sur la commande de gain variable.

Il est aussi connu l'utilisation, pour améliorer les performances du contrôle automatique, que le dispositif 104 de détermination du gain d'amplification puisse prendre en compte les perturbations du signal générées par le dispositif 102 d'amplification. Cependant dans les systèmes de l'état de la technique cette prise en compte des perturbations est statique, c'est à dire qu'elle n'utilise pas d'estimateur afin de remettre à jour le modèle des perturbations du dispositif d'amplification. Ainsi ces systèmes peuvent engendrer une instabilité si le gain et le retard de la chaine radio sont différents des valeurs attendues.

La présente invention vise donc à remédier à ces problèmes en proposant un système d'amplification, relié à un modem délivrant un signal à amplifier. Ce système comporte au moins un dispositif d'amplification dont un gain d'amplification est variable. Il comporte aussi au moins un premier dispositif de détermination d'une première différence entre un signal amplifié et le signal à amplifier. Ce système comporte de plus au moins un deuxième dispositif de détermination du gain variable à partir dudit signal à amplifier, dudit signal amplifié et de ladite première différence. Ce deuxième dispositif comporte au moins un troisième dispositif de détermination d'un modèle de la perturbation de la première différence par ledit dispositif d'amplification à partir dudit signal à amplifier et dudit signal amplifié, ledit modèle comprenant un retard et un gain. Ce deuxième dispositif comporte aussi au moins un quatrième dispositif de détermination de perturbations de la première différence, provoquées par ledit dispositif d'amplification, à partir dudit modèle et dudit signal à amplifier. Le deuxième dispositif comporte aussi au moins un cinquième dispositif de détermination d'une deuxième différence entre ladite première différence et lesdites perturbations et un contrôleur apte à déterminer ledit gain variable à partir de ladite deuxième différence.

Dans un mode de réalisation le système d'amplification comporte au moins un dispositif d'extraction, du signal amplifié, vers le premier dispositif de détermination. Ce dispositif d'extraction comprend un coupleur directionnel servant à récupérer le signal transmis sur un fil reliant le dispositif d'amplification et une antenne. Il comporte aussi au moins un dispositif de réglage du gain du signal récupéré. Il comporte ensuite un mélangeur du signal dont le gain a été réglé avec un signal sinusoïdal. Ce coupleur comporte aussi une pluralité de filtres pour filtrer le signal mélangé, ces filtres comprennent au moins un filtre analogique à bande passante fixe servant d'anti-repliement et/ou d'antibrouillage et au moins un filtre numérique commutable à bande passante variable en fonction d'une bande passante dudit signal à amplifier et/ou d'un écart entre une fréquence dudit signal à amplifier et une fréquence desdites perturbations.

Dans un mode de réalisation le premier dispositif de détermination est relié directement au modem.

Dans un mode de réalisation le contrôleur est un contrôleur PID.

Dans un mode de réalisation le deuxième dispositif de détermination comporte une table de conversion mettant en relation une puissance dudit signal à émettre et le gain d'amplification.

La présente invention propose aussi un procédé d'utilisation du système d'amplification comportant les étapes successives suivantes :

- une étape de configuration du gain dudit dispositif d'amplification, ladite étape de configuration étant réalisée lorsque ledit signal à amplifier est de puissance nulle,
- une étape d'augmentation du gain d'amplification du dispositif d'amplification, lors d'une phase d'initialisation, durant laquelle ledit signal à amplifier ne comporte pas de données utiles, et
- une étape de désactivation de la régulation du gain, ladite étape de désactivation étant réalisée lorsque le signal à amplifier comporte des données utiles.

Dans un mode de réalisation le procédé comporte une étape de régulation du gain d'amplification du dispositif d'amplification. Cette étape de régulation du gain d'amplification est effectuée après l'étape d'augmentation du gain d'amplification. De plus cette étape de régulation est réalisée à partir d'une consigne.

Dans un mode de réalisation l'étape de configuration est adaptée pour la mise en oeuvre de la relation

$$Pout\_max = Pout\_mean\_consigne\_MODEM + Facteur\_crete\_modulation$$

où ;

- *Pout_max* représente en dBm la puissance de sortie maximum,
- *Pout_mean_consigne_MODEM* représente en dBm la puissance moyenne du signal que va émettre ledit modem (101) et
- *Facteur_crete_modulation* représente en dB le facteur de crête de la modulation du signal qui va être émis par ledit modem (101).

De plus l'étape de configuration est adaptée pour configurer le dispositif d'amplification afin de pouvoir transmettre une puissance de sortie maximum de *Pout_max.*

La détermination de *Pout_max* par ce calcul permet de configurer le gain à appliquer sur le signal de consigne (gain de consigne) afin de le comparer au signal reçu sur la voie de mesure.
A partir de la valeur de *Pout_max,* des tables de calibration de la voie de mesure et de la voie d'émission sont adressées. Elles contiennent les valeurs du gain de consigne et la configuration des éléments à gain variables de la voie de mesure et de la voie d'émission correspondant à priori à la puissance *Pout_max.*

Dans un mode de réalisation l'étape d'augmentation du gain d'amplification est mise en oeuvre au moyen d'une table de conversion mettant en relation une puissance dudit signal à émettre et le gain d'amplification lorsque la puissance dudit signal à amplifier est inférieure à un seuil; et au moyen du contrôleur lorsque la puissance dudit signal à amplifier est supérieure à ce seuil.

Ainsi le système et le procédé décrit dans l'invention offrent les avantages suivants :

Le retard dans la boucle principale, engendré par les filtres du système d'amplification nécessaires au fonctionnement co-site, est éliminé de l'erreur de gain (première différence) grâce à l'estimateur du modèle de perturbation du signal par le système d'amplification.

Le fonctionnement co-site est réalisé lorsque différents systèmes radio sont situés dans une zone géographique proche. Cette zone géographique est définie par un cercle dont le rayon est de l'ordre de la dizaine de mètres.

De plus la modélisation du signal tel que perturbé par le système d'amplification et l'utilisation des échantillons modulés comme référence pour le calcul de la première différence permettent d'augmenter significativement la bande passante de la boucle principale et de la rendre indépendante de la bande passante du signal à amplifier. La bande passante de la boucle peut alors être choisie uniquement pour satisfaire le temps de montée requis par la forme d'onde (dans le cas d'une forme d'onde changeant régulièrement de fréquence d'émission connu aussi sous l'expression forme d'onde EVF). La bande passante de boucle caractérise le comportement du système en boucle fermée. Elle est calculée à partir de la fonction de transfert en boucle fermée du système.

Cette fonction de transfert dans le cas de cette invention inclue la contribution de tous les filtres de la voie émission et de la voie de mesure (assimilés à leur fonction de transfert) et la fonction de transfert du contrôleur.

Si $A(p)$ est la fonction de transfert de la chaine d'émission associée au contrôleur et $B(p)$ la fonction de transfert de la voie de mesure. La fonction de transfert en boucle fermé (connu aussi sous l'acronyme FTBF) vaut :

$$FTBF = \frac{A(p)}{1 + A(p) * B(p)}$$

L'estimateur de la perturbation du signal provoqué par le dispositif d'amplification permet d'obtenir une commande de gain optimale et stable ce qui rend possible le contrôle de gain de manière continue y compris durant la phases contenant des données utiles et pour des formes d'ondes à enveloppe non constante.

C'est un système asservi qui permet de réduire de manière très significative le nombre de tables de calibration, de la partie radio fréquence du système, qu'il est nécessaire de déterminer au moment de la réalisation du système.

Dans les systèmes non asservis, la précision de la puissance émise dépend de la précision de calibration de la voie émission. Or la voie d'émission comporte un nombre importants d'éléments non linéaires (amplificateurs, filtres accordables..). Son gain dépend alors fortement de la puissance émise de la température et de la fréquence. Il est donc nécessaire de faire une calibration sur toute la plage de fonctionnement que le poste radio peut couvrir.

La précision du système de l'invention dépend uniquement de la précision de la calibration de la voie de mesure. Comme la voie de mesure ne comporte que des éléments linéaires, elle est plus facile et plus rapide à calibrer que la voie d'émission.

Le premier dispositif de détermination 103 relié directement audit modem 101 permet d'utiliser directement les échantillons en provenance du modem pour effectuer le contrôle du gain.

Comme le système met en oeuvre des dispositifs de détermination des perturbations du signal à amplifier associés à un estimateur du modèle des perturbations provoquées par les dispositifs d'amplification, le système de d'amplification permet une puissance du signal amplifié précise, même en environnement sévère. L'environnement sévère se traduit par deux phénomènes :

- La mobilité du poste radio, induisant des variations de charge pour l'amplificateur. De plus cette variation de charge ajoutée à la désadaptation entre l'antenne et l'amplificateur entraine des variations importantes du gain de l'amplificateur et de la puissance incidente.
- Le fonctionnement avec un brouilleur co-site, c'est à dire avec un émetteur à proximité.

Ce système permet d'asservir de manière continue les formes d'onde à enveloppe non constante rendant possible l'utilisation de techniques de linéarisation. En effet, l'utilisation d'une technique de linéarisation nécessite une maitrise parfaite du gain de la chaine car les non-linéarités ne sont corrigeables que pour des petites variations autour du point de fonctionnement. Ainsi la linéarisation par pré distorsion nécessite un modèle de l'amplificateur. Ce modèle est valable pour un point de fonctionnement précis notamment caractérisé par la puissance moyenne d'émission, la fréquence d'émission et la température.

Dans un mode de réalisation l'utilisation d'un mélangeur associé au dispositif anti-brouillage rend possible l'asservissement en puissance dans une situation co-site (Cette situation est réalisée lorsque différents systèmes radio sont situés dans une zone géographique proche. Cette zone géographique est définie par un cercle dont le rayon est de l'ordre de la dizaine de mètres). De plus l'utilisation d'un mélangeur (qui a une réponse linéaire en tension) plutôt que d'un détecteur logarithmique facilite l'asservissement car il n'est plus nécessaire d'utiliser des tables de conversions.

Ces tables de conversions permettent la conversion d'une information de type logarithmique vers une information de type linéaire.

L'invention sera mieux comprise et d'autres avantages apparaîtront à la lecture de la description détaillée faite à titre d'exemple non limitatif et à l'aide des figures parmi lesquelles :

- La figure 1 présente un système selon l'état de la technique.
- La figure 2 présente le système utilisant le procédé de l'invention.
- La figure 3 présente l'atténuateur variable commandé en tension.
- Les figures 4.a à 4.c présentent le modèle de perturbation du signal par le dispositif d'amplification.
- La figure 4d présente l'atténuateur variable commandé en tension.
- La figure 5 présente le système utilisant une table de conversion.
- La figure 6 présente le procédé d'utilisation du système.
- La figure 7 présente les différentes phases d'utilisation d'un signal EVF.
- La figure 8 présente un mode d'implémentation du système.

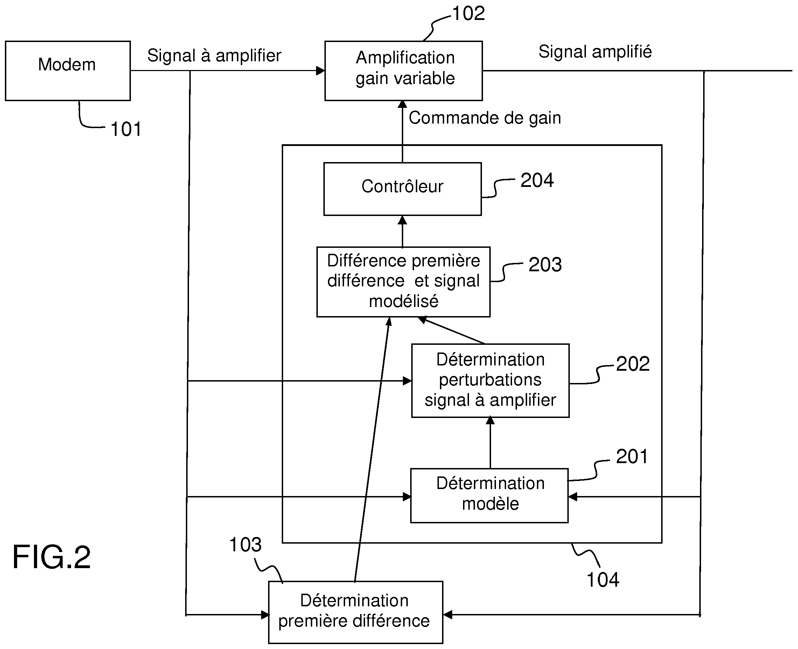

La figure 2 décrit le système selon un premier aspect de l'invention. Dans ce mode de réalisation le modem 101 est relié au système d'amplification. Le système d'amplification comporte :

- un dispositif 102 d'amplification du signal émis par le modem. Ce dispositif 102 d'amplification présente un gain variable,
- un premier dispositif 103 de détermination d'une première différence entre le signal amplifié par le dispositif 102 et le signal à amplifier délivré par le modem 101,
- un deuxième dispositif 104 de détermination du gain variable du dispositif d'amplification 102.

Le deuxième dispositif 104 de détermination du gain variable effectue cette détermination à partir de :

- la différence calculée par le premier dispositif 103 de détermination,
- du signal à amplifier émis par le modem 101 et
- du signal amplifié par le dispositif d'amplification 102.

Ce deuxième dispositif comporte:

- un troisième dispositif de détermination 201 d'un modèle de la perturbation de la première différence par le dispositif d'amplification et éventuellement le dispositif d'extraction 301 (cette détermination du modèle est réalisée à partir du signal à amplifier et du signal amplifié),
- un quatrième dispositif de détermination 202 de la perturbation de la première différence utilisant le signal à amplifier et le modèle obtenu par le troisième dispositif 201,
- un cinquième dispositif de détermination 203 d'une deuxième différence entre la première différence, obtenue par le premier dispositif, et la perturbation déterminée par le quatrième dispositif et
- un contrôleur 204 apte à déterminer le gain variable à partir de la deuxième différence.

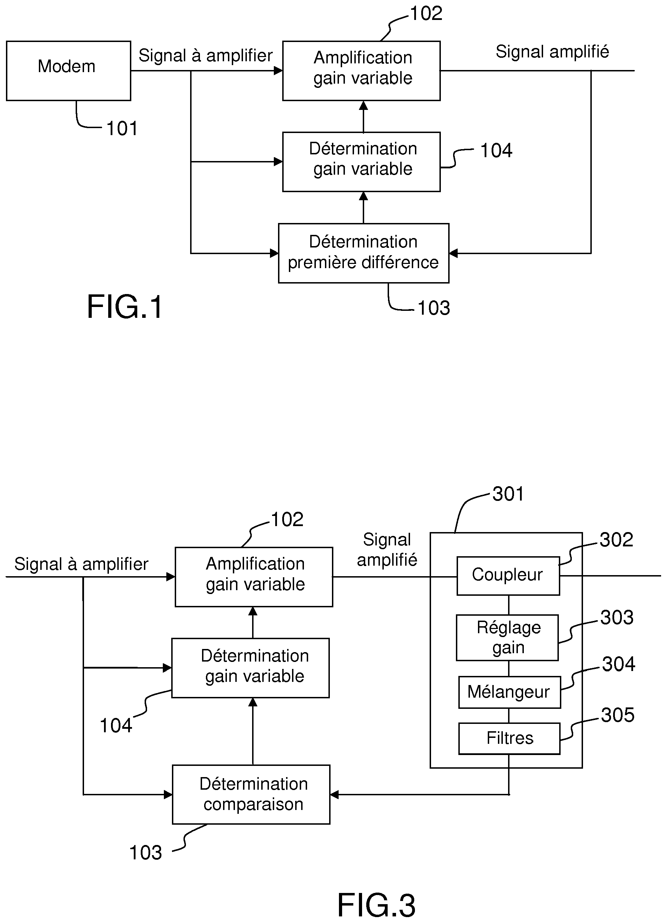

Dans un mode de réalisation présenté figure 3, le système comporte un dispositif d'extraction 301 du signal amplifié au premier dispositif de détermination d'une différence.
Ce dispositif d'extraction 301 comprend :

- un coupleur directionnel 302 qui permet de récupérer le signal transmis sur un fil reliant le dispositif d'amplification 102 et l'antenne d'émission,
- au moins un dispositif 303 de réglage du gain du signal récupéré,
- un mélangeur analogique 304, qui permet de mélanger le signal dont le gain a été réglé par le dispositif de réglage du gain avec un signal sinusoïdale, le signal sinusoïdal est l'oscillateur local qui est partagé entre le mélangeur émission et mélangeur de la voie de mesure pour assurer une cohérence entre la phase du signal émis et la phase du signal reçu,
- et une pluralité de filtres 305 adaptés au filtrage du signal mélangé. Ces filtres peuvent être utilisés pour réaliser une fonction d'anti-brouillage, ils sont alors adaptés au signal à amplifier et à l'écart fréquentiel entre le signal à amplifier et le signal brouilleur. L'invention peut comporter plusieurs types de filtres :

    ◦ un filtre analogique à bande passante fixe servant d'anti-repliement et d'antibrouillage et
    ◦ plusieurs filtres numériques commutables à bande passante variable. La configuration des filtres numériques est réalisée en fonction de la bande passante du signal à émettre et de l'écart fréquentiel prévu du signal brouilleur.

Le modèle de perturbations du signal à amplifier, provoquées par le dispositif d'amplification et le dispositif d'extraction 301, comporte un retard pur et un gain.

Le troisième dispositif 201 utilise un corrélateur de type amplitude différence qui travaille en temps différé pendant le début de l'utilisation du contrôleur automatique de gain. Afin de déterminer la valeur de ce retard et de ce gain le troisième dispositif utilise la fonction de corrélation $R(m)$ entre le signal à amplifier $x(n)$ et le signal amplifié $z(n)$. Cette corrélation s'exprime en utilisant la relation suivante:

$$R(m) = \sum_{n=0}^{N} D[x(n)] * D[z(n+m)] \ m \in [-N, N]$$

$$D[x(n)] = sign[|x(n)| - |x(n-1)|]$$

$$sign(d) = \begin{cases} 1 \ d > 0 \\ 0 \ d = 0 \\ -1 \ d < 0 \end{cases}$$

La détermination du modèle de perturbation produit une estimée $mean\_g$ du gain moyen total et $Tg$ du retard pur total de la boucle (ces valeurs dépendent du nombre d'échantillons).

$Tg$ est donné par l'indice $m$ de la valeur maximum de la fonction $R(m)$ $mean\_g$ est la valeur moyenne du gain instantané entre le signal reçu sur la voie de mesure $sig\_out$ et le signal émis et retardé de $Tg$ $sig\_in\_del$:

$$mean\_g = mean(G\_inst) = mean\left(\frac{abs(sig\_out(n))^2}{abs(sig\_in\_del(n))^2}\right)$$

La valeur de $mean\_g$ est corrigée de la valeur du gain variable (le gain de l'atténuateur variable commandé en tension désigné par l'acronyme GVVA) pour donner une estimée du gain statique $G\_stat.$

Le dispositif de détermination 202 de la perturbation de la première différence adapte le fonctionnement d'un prédicteur de Smith au cas d'un signal modulé qui associé au retard pur de la chaine radio induit une perturbation du signal d'erreur. Le dispositif 202 détermine le signal de perturbation $S_{corr}(n)$ grâce à la formule suivante :

$$S_{corr}(n) = GVVA(n) * G\_stat * (abs(sig\_in(n))^2 - abs(sig\_in\_del(n)^2))$$

Où:

- $sig\_in$ représente le signal modulé d'entrée,
- $sig\_in\_del,$ le signal modulé d'entrée retardé de $Tg,$
- $GVVA(n)$ est le gain modélisé de l'atténuateur variable,
- $G\_stat$ est un gain statique determiné à partir de $mean\_g,$ du gain de consigne et de la valeur moyenne de $GVVA$ sur la durée nécessaire à la corrélation :

$$G_{stat} = mean\_g \ / mean(GVVA)$$

- $GVVA(n) * G\_stat * (abs(sig\_in(n))^2$ est un terme non retardé
- $GVVA(n) * G\_stat * (abs(sigin\_del(n))^2$ est un terme retardé de Tg

Le signal $S_{corr}(n)$ est soustrait au signal d'erreur principal $Erreur(n)$ issu du dispositif 103 de détermination de la première différence. Ce nouveau dispositif est le dispositif 203 de détermination du signal d'erreur corrigé *E_corr*(*n*) donc :

$$E\_corr(n) = Erreur(n) - S_{corr}(n)$$

Il est connu dans l'état de la technique que le prédicteur de Smith fonctionne de la manière suivante:

- La technique de prédicteur de Smith permet d'éliminer la contribution du temps de groupe dans l'asservissement en modifiant la fonction de transfert en boucle fermée.
- Une deuxième boucle est ajoutée au sytème bouclé principal. Cette boucle utilise un modèle de la fonction de transfert en aval du contrôleur PID et permet de corriger le signal d'erreur principal :

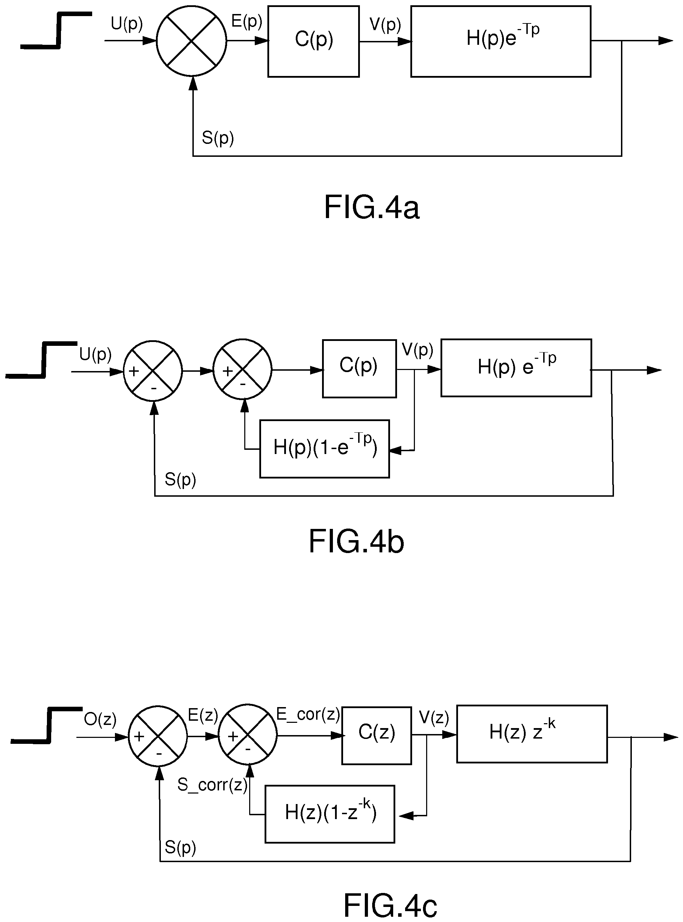

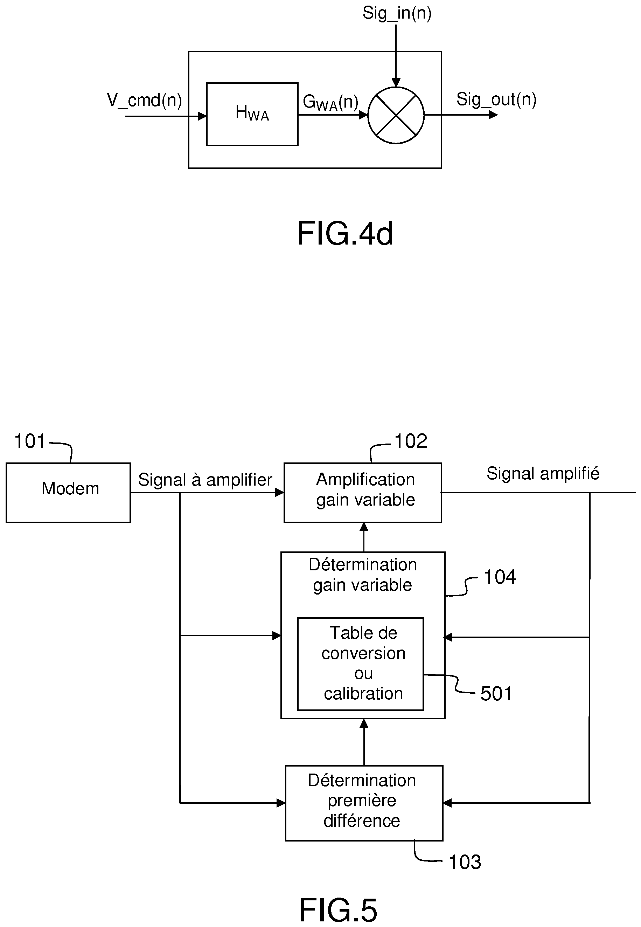

La figure 4.a présente un exemple classique d'un système bouclé possédant un retard. Dans ce système la fonction de transfert C(p) correspond à un contrôleur. La fonction de transfert $H(p)e^{-Tp}$ correspond au reste de la boucle. Dans le cas de la présente invention, il est assimilé à l'ensemble constitué de la voie émission et de la voie de mesure.

La fonction de transfert en boucle ouverte (*FTBO'*) d'un système bouclé sans retard pur s'exprime par:

$$FTBO' = C(p) * H(p)$$

La fonction de transfert en boucle fermée (*FTBF'*) d'un système bouclé sans retard pur s'exprime par:

$$FTBF' = \frac{FTBO'}{1 + FTBO'}$$

$$FTBF' = \frac{C(p) * H(p)}{1 + C(p) * H(p)}$$

La fonction de transfert en boucle ouverte (*FTBO*) d'un système bouclé avec retard pur s'exprime par :

$$FTBO = C(p) * H(p)e^{-Tp}$$

La fonction de transfert en boucle fermée (*FTBF*) d'un système bouclé avec retard pur s'exprime par:

$$FTBF = \frac{FTBO}{1 + FTBO}$$

$$FTBF = \frac{C(p) * H(p)e^{-Tp}}{1 + C(p) * H(p)\, e^{-Tp}}$$

On remarque que le retard pur apparaît dans le dénominateur ce qui ne permet pas d'obtenir une stabilité inconditionnelle quelque soit la valeur du retard pur.

Pour palier ce problème, il est possible de synthétiser un nouveau contrôleur C'(p) permettant d'éliminer le retard du dénominateur de la fonction FTBF.

Pour cela, il faut calculer la fonction de transfert *FTBF''* avec le nouveau contrôleur C'(p) qui serait égale à :

$$FTBF'' = \frac{C'(p) * H(p)e^{-Tp}}{1 + C'(p) * H(p)e^{-Tp}} = FTBF' * e^{-Tp}$$

On obtient alors :

$$\frac{C'(p) * H(p)\, e^{-Tp}}{1 + C'(p) * H(p)\, e^{-Tp}} = \frac{C(p) * H(p)\, e^{-Tp}}{1 + C(p) * H(p)}$$

En résolvant l'égalité, ci-dessus on obtient l'expression du nouveau contrôleur C'(p) :

$$C'(p) = \frac{C(p)}{1 + C(p) * H(p) * (1 - e^{-Tp})}$$

La figure 4.b illustre la nouvelle boucle ainsi constituée.

La figure 4.c présente cette boucle dans le domaine numérique.

Sur cette figure 4.c la boucle secondaire réalise la fonction de transfert :

$$H(z)(1 - z^{-k})$$

Le signal d'erreur principal $E(z)$ est soustrait du signal de sortie du prédicteur de Smith $S\_corr(z)$ pour constituer une erreur corrigée $E\_cor(z)$.

$$E\_cor(n) = Erreur(n) - Scorr(n)$$

Le signal $E\_cor(z)$ est envoyé au contrôleur de fonction de transfert $C(z)$.

Le signal $S\_corr$ généré par le quatrième dispositif 203 de détermination de l'erreur corrigée grâce à la relation suivante

$$S_{corr}(n) = GVVA(n) * G\_stat * (abs(sig\_in(n))^2 - abs(sig\_in\_del(n)^2))$$

est une généralisation de la technique de prédicteur de Smith au cas d'une fonction de transfert aval $H(z)$ incluant la contribution des échantillons modulés. On peut décomposer la formule $H(z)(1 - z^{-k})$ de la manière suivante :

- Fonction de transfert aval non retardée : $H(z)$
- Fonction de transfert aval retardée $H(z)z^{-k}$

On peut identifier les termes retardés et non retardés de la formule suivante :

$$S_{corr}(n) = GVVA(n) * G\_stat * (abs(sig\_in(n))^2 - abs(sig\_in\_del(n)^2))$$

avec les termes retardés et non retardés de la formule du prédicteur de Smith :

- $H(z)$ correspond à $GVVA(n) * G\_stat * abs(sig\_in(n))^2$
- $H(z)z^{-k}$ correspond à $GVVA(n) * G\_stat * abs(sig\_in\_del(n))^2$

Le terme $GVVA(n) * G\_stat * abs(sig\_in\_del(n))^2$ modélise l'atténuateur variable, l'amplificateur ainsi que la voie de mesure. Ces éléments sont considérée comme linéaires et sont « contenus » dans le retard et le gain statique ($Tg$ et $G\_stat$). Afin d'obtenir le gain GVVA, il est nécessaire de modéliser l'atténuateur variable commandé en tension

L'atténuateur variable est modélisé comme un gain variable commandé en tension soit un système à deux entrées et une sortie. La figure 4.d présente le modèle de cet atténuateur. La réponse en gain $GVVA$ de l'atténuateur à une commande de tension est modélisée par une fonction de transfert d'ordre 2 associée à un retard pur et à un offset. Cette fonction de transfert est établie à partir de mesures d'un composant ciblé pour implémenter la fonction de contrôle automatique de gain.

La fonction de transfert $HVVA(p)$ est identifiée à partir de mesure et prend la forme suivante:

$$HVVA(p) = \frac{GVVA_0(p)}{V\_cmd(p)} = \frac{Katt * e^{-Tatt*p}}{(1 + \tau att * p^2)} + off\_att$$

Cette relation permet de modéliser le gain de l'atténuateur par une fonction de transfert passe bas d'ordre deux associée à un retard pur.

$V\_cmd(p)$ représente la tension de commande de l'atténuateur.

$GVVA_0(p)$ représente le gain modélisé de l'atténuateur.

$Katt$ représente gain de l'atténuateur.

$e^{-Tatt*p}$ représente le retard pur de l'atténuateur vis-à-vis de sa tension de commande.

$1 + \tau att * p^2$ représente le dénominateur d'une fonction passe bas d'ordre 2. $off\_att$ représente l'offset en gain, ainsi lorsque la tension de commande est nulle, le gain n'est pas nul. Cet offset permet de modéliser la dynamique d'atténuation du composant qui est limitée.

- Transposition de la partie polynomiale de la fonction de transfert $HVVA(p)$ dans le domaine numérique par une transformation bilinéaire.
- Modélisation du retard pur $e^{-Tatt*p}$ par un filtre passe-tout de type filtre de Thiran. Le filtre de Thiran T(z) est une approximation connue permettant de synthetiser un retard qui est fractionnaire par rapport à la période d'échantillonnage. La fonction de transfert du filtre de Thiran est donnée par l'équation suivante :

$$T(z) = z^{-N} D(z^{-1})/D(z)$$

$$D(z) = 1 + a_1 z^{-1} + \cdots + a_N z^{-N}$$

Le calcul des coefficients du filtre s'effectue grâce à l'équation suivante :

$$a_k = (-1)^k \binom{N}{k} \prod_{n=0}^{N} \frac{d+n}{d+k+n},$$

$$N = ceil(D),$$

avec $D = Tg * Fs$ $Fs$ représente la fréquence d'échantillonage,

$$d = D - N.$$

- Enfin la fonction de transfert finale dans le domaine numérique $HVVA(z)$ est obtenue en faisant la convolution des fonctions de transfert primaires. La fonction de transfert finale $HVVAt(z)$ est le produit de la transformée bilinéaire (dans le domaine z) de la fonction de transfert $HVVA(p)$ et la fonction de transfert du filtre de Thiran $T(z)$.

$$HVVAt(z) = HVVA(z) * T(z)$$

Si l'on considère les échantillons discrets des deux filtres cela revient à faire le produit de convolution entre les échantillons des deux filtres $HVVA(n)$ et $T(n)$.

Le filtre à réponse impulsionnelle infinie, représentant $HVVAt(z)$, ainsi obtenu est, dans un mode de réalisation non limitatif, d'ordre 6 (convolution d'un filtre d'ordre 2 et d'un filtre d'ordre 3 pour le retard).

Afin de modéliser la non linéarité de l'atténuateur et de la chaine d'émission, les échantillons $GVVA_0(n)$ issus du filtre $HVVA(z)$ sont multipliés par une fonction polynomiale.

La fonction polynomiale est appliquée directement sur les échantillons $GVVA_0(n)$ afin d'obtenir le gain $GVVA(n)$ grace à la formule suivante :

$$GVVA(n) = \sum_{k=0}^{K} ak\, GVVA_0{}^k$$

La figure 5 décrit le système dans lequel le deuxième dispositif de détermination 104 comporte une table de conversion 501 qui permet la mise en relation entre une puissance dudit signal à émettre et le gain d'amplification.

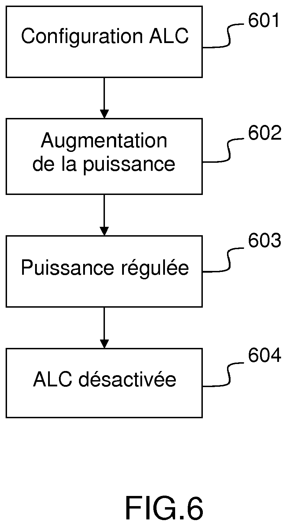

La figure 6 décrit un premier mode de réalisation du procédé de mise oeuvre du système décrit dans cette invention. Ce procédé comporte les étapes suivantes :

- une étape 601 de configuration du gain du dispositif d'amplification, cette étape de configuration est réalisée lorsque le signal amplifié est de puissance nulle,
- une étape 602 d'augmentation du gain d'amplification du dispositif d'amplification,
- une étape 603 de régulation du gain d'amplification du dispositif d'amplification. Le régime de régulation est obtenu au bout du temps nécessaire à l'estimateur pour mettre à jour les paramètres de gain et de retard (*mean_g* et *Tg*) du dispositif de correction de l'erreur.
- une étape 604 de désactivation de la régulation du gain, cette étape de désactivation est réalisée lorsque le signal à amplifier comporte des données utiles.

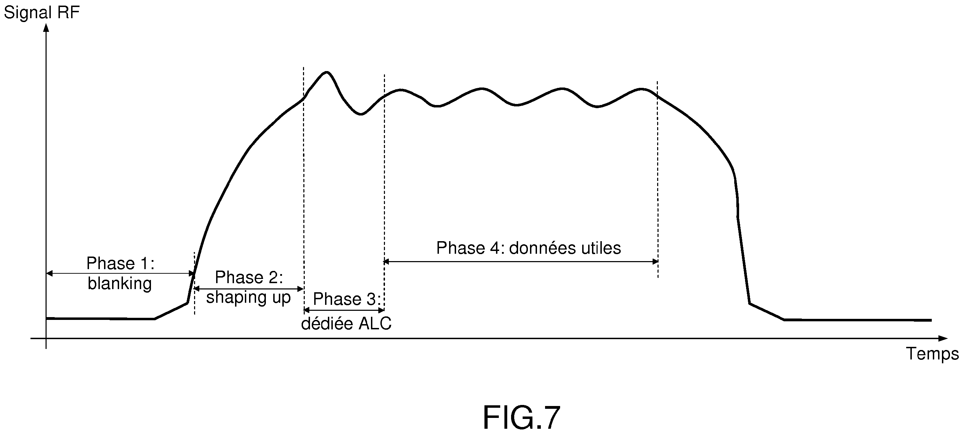

Ainsi lors de l'utilisation du système pour amplifier des signaux présentant des variations rapides de la fréquence de modulation (ces signaux sont aussi connus sous l'expression signaux EVF pour Evasion de Fréquence) quatre phases de fonctionnement distinctes sont présentes. Ces phases sont présentées figure 7 et sont les phases suivantes :

- Une première phase appelée phase de « blanking». Durant cette phase, la puissance du signal est mise à zéro. Ainsi aucun signal n'est émis par l'antenne. Cette phase est aussi appelée « trou de palier » et elle est utilisée pour réaliser la configuration des différents dispositifs d'une radio (positionnement en fréquence et routage des interrupteurs notamment). Ce temps est utilisé pour mettre en oeuvre l'étape 601 de configuration du gain du dispositif d'amplification. Ceci est réalisé, dans un mode de réalisation, en utilisant la relation suivante :

$$Pout\_max = Pout\_mean\_consigne\_MODEM + Facteur\_crete\_modulation$$

dans cette relation ;

- *Pout_max* représente la puissance de sortie maximum,
- *Pout_mean_consigne_MODEM* représente la puissance moyenne du signal que va émettre le modem et
- *Facteur_crete_modulation* représente le facteur de crête de la modulation du signal qui va être émis par le MODEM.

De plus durant l'étape de configuration 601 le dispositif d'amplification 102 est configuré pour permettre la transmission d'un signal de puissance maximale *Pout_max.*

La détermination de *Pout_max* par ce calcul permet de configurer le gain à appliquer sur le signal de consigne (gain de consigne) afin de le comparer au signal reçu sur la voie de mesure.

A partir de la valeur de *Pout_max,* des tables de calibration de la voie de mesure sont adressées. Elles contiennent les valeurs du gain de consigne et la configuration des éléments à gain variables de la voie de mesure correspondant à la puissance *Pout_max.*

- Une deuxième phase appelée phase de « shaping », cette phase permet la montée en puissance du signal émis. La qualité de la montée en puissance est très importante car elle influence la largeur du spectre du signal émis par l'antenne. Cette phase est réalisée via l'étape 602 d'augmentation du gain d'amplification du dispositif d'amplification. Dans un mode de réalisation illustratif, cette étape peut être réalisée par la configuration du deuxième dispositif de détermination 104 afin qu'ils utilisent la table de conversion 401, lorsque la puissance dudit signal à amplifier est inférieure à un seuil et par la configuration du deuxième dispositif de détermination 104 afin d'utiliser le contrôleur 204, lorsque la puissance du signal à amplifier est supérieure à ce seuil. Ce seuil est variable et est fixé par configuration. Il dépend de la puissance du signal brouilleur attendu sur la voie de mesure. Dans un mode de réalisation ce seuil à une valeur typique comprise entre -20dB et -5dB avec une valeur préférentielle de -15dB. Soit S/J le rapport entre la puissance du signal utile et la puissance maximum attendue du signal brouilleur sur la voie de mesure après les filtres anti-brouillage. Le seuil de déclenchement vaut alors :

$$Seuil = S/J(dB) + 10dB$$

- Une troisième phase appelée phase « dédiée ALC », il s'agit de la phase durant laquelle l'ensemble des traitements nécessaires au réglage du gain du dispositif d'amplification doivent être réalisés. La durée de cette phase peut être variable. Durant cette phase l'étape 603 de régulation est utilisée. Durant cette étape de régulation 603 le gain de consigne utilisé est celui déterminé durant l'étape 601 de configuration en utilisant la relation

$$Pout\_max = Pout\_mean\_consigne\_MODEM + Facteur\_crete\_modulation$$

et les tables de calibration.

- Enfin la quatrième phase correspond à la phase d'envoi des données utiles. Dans un mode de réalisation le gain du dispositif d'amplification doit être stabilisé au début de cette phase et ne doit ensuite plus évoluer. Cette phase correspond à l'étape 604 de désactivation de la régulation du gain.

Lorsque la forme d'onde fonctionne en mode continu, l'étape 603 de régulation du gain n'est pas matérialisée explicitement. Le système d'amplification doit donc être capable de réguler le gain sans dégrader les données utiles.
Cependant dans le cas où une forme d'onde continue prévoit explicitement une phase dédiée au contrôle automatique du gain, alors le fonctionnement du système d'amplification est identique au fonctionnement en EVF avec en plus des transitions de l'étape 604 de désactivation de la régulation vers l'étape 603 de régulation du gain. Dans ce cas, l'intervalle temporel durant lequel l'étape 603 de régulation du gain est réalisée doit être signalé au dispositif de contrôle de gain afin qu'il puisse adapter le modèle des perturbations. Cet intervalle doit être compatible de la détermination effectuée par le dispositif de détermination 201 du modèle.
Dans un mode de réalisation le modem et le système d'amplification s'échangent un certain nombre de paramètres représentatifs de la forme d'onde qui doit être amplifiée. Ces paramètres peuvent être échangés au moment du chargement de la forme d'onde ou durant l'utilisation de la forme d'onde et comportent :

- La puissance de sortie RMS (dBm) désirée en sortie d'amplificateur
- Le facteur crête de la modulation (dB) du signal à amplifier.
- La bande passante de modulation (Hz) du signal amplifié.
- La fréquence d'émission

L'information de bande passante permet d'adresser des tables contenant les paramètres de la boucle de régulation, notamment les coefficients du contrôleur P (constante d'intégration, gain) et des filtres numériques de la voie de mesure.

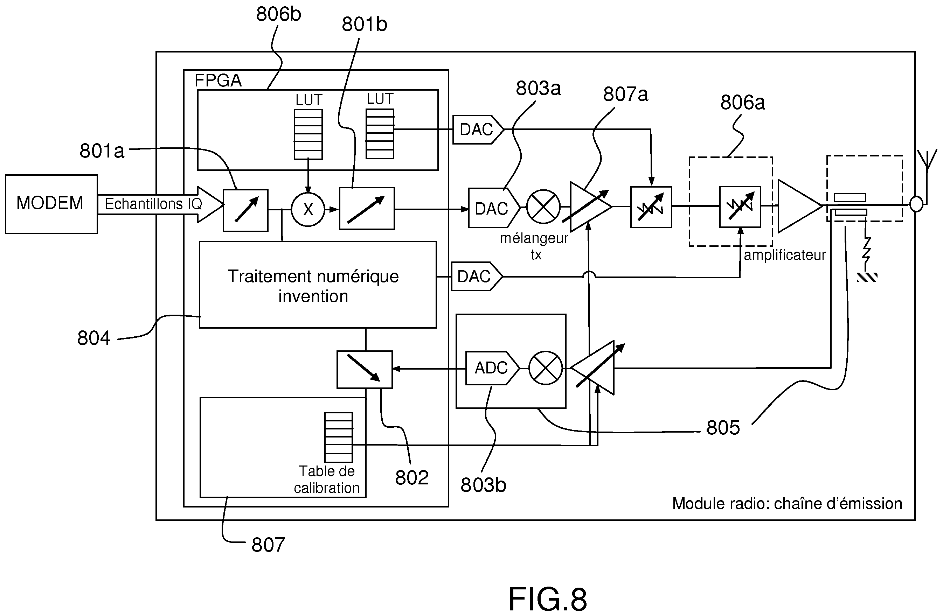

La figure 8 présente un mode d'implémentation du système de l'invention. Dans cette implémentation le système comprend les éléments suivants :

- Des filtres DUC (pour Digital Up Converter en anglais ou filtres sur-échantillonneurs en Français) qui permettent de convertir le signal depuis une fréquence de base vers une fréquence intermédiaire. Sur la figure 8 ces filtres sont référencés 801.a et 801.b.
- Un filtre DDC (pour Digital Down Converter en anglais ou filtres sous-échantillonneurs en Français) qui permettent de convertir le signal depuis une fréquence intermédiaire vers une fréquence de base. Sur la figure 8 ce filtre est référencé 802.
- Deux convertisseurs numérique vers analogique (connu aussi sous l'expression anglaise de DAC pour Digital to Analog Converter) qui sont référencés 803.a et 803.b sur la figure 8.
- Une partie traitement numérique de l'invention qui est référencée 804 sur la figure 8. Cette partie traitement numérique de l'invention (constituée de la boucle principale et la boucle à commande prédictive) doit être mise en oeuvre entre la chaine de traitement numérique des échantillons modulés émis et le Convertisseur Numérique-Analogique de la voie d'émission. Cette partie correspond aux éléments 103 et 104.
- Une partie détection sélective en fréquence qui est référencée 805 sur la figure 8. Cette partie détection sélective en fréquence doit être matérialisée par un coupleur directif disposé entre la sortie de l'amplificateur de puissance et l'antenne, un dispositif de réglage de gain, un mélangeur, un Convertisseur Analogique-Numérique et un ensemble de filtres analogiques et numériques réparties le long de la chaine de détection. Un système de pré-positionnement de gain est également utilisé dans la voie de détection afin de rendre le gain de la boucle quasiment constant pour une grande plage de puissance de fonctionnement (de l'ordre de 25dB) facilitant ainsi la stabilité de la boucle principale. Cette partie correspond aux éléments 302, 303, 304 et 305 de la figure 3.

- L'invention implémente deux commandes de gain en boucle ouverte, référencées 806.a et 806.b, destinées à la mise en forme de palier (durant la phase de « shaping ») au moyen de plusieurs tables de conversion utilisant des coefficients statiques (LUT), d'un gain numérique disposé dans la chaine de traitement numérique du signal émis et d'un atténuateur analogique contrôlé en tension avec un Convertisseur Numérique-Analogique. Ces commandes sont intégrées dans le deuxième dispositif de détermination 104.

- L'invention implémente une commande de gain en boucle fermée utilisant les deux boucles de traitement numérique revendiquées dans l'invention et un atténuateur analogique contrôlé en tension avec un Convertisseur Numérique-Analogique. Cette commande est intégrée dans le deuxième dispositif de détermination 104.

- L'algorithme du procédé de l'invention s'adapte plus particulièrement aux formes d'onde de type EVF mais peut être adaptée facilement à des formes d'onde de type continu car elle possède un mode de régulation rendant possible son activation pendant la phase utile de la modulation.

- Le système comporte aussi un dispositif 807 de repositionnement des gains statiques 807.a et du gain du dispositif de réglage de gain 303 qui utilise une table de calibration.

## Revendications

1. Système d'amplification, relié à un modem (101) délivrant un signal à amplifier, ledit système comportant :

   • au moins un dispositif d'amplification (102) dont un gain d'amplification est variable,
   • au moins un premier dispositif de détermination (103) d'une première différence entre un signal amplifié et ledit signal à amplifier,
   • au moins un deuxième dispositif de détermination (104) dudit gain variable à partir dudit signal à amplifier, dudit signal amplifié et de ladite première différence,

   ledit système étant **caractérisé en ce que** ledit deuxième dispositif comporte :

   • au moins un troisième dispositif de détermination (201) d'un modèle d'une perturbation de la première différence par le dispositif d'amplification au moyen d'une corrélation entre ledit signal à amplifier et ledit signal amplifié, ledit modèle comprenant un retard et un gain,
   • au moins un quatrième dispositif de détermination (202) de perturbations de la première différence provoquées par ledit dispositif d'amplification, à partir dudit modèle et dudit signal à amplifier
   • au moins un cinquième dispositif de détermination (203) d'une deuxième différence entre ladite première différence et lesdites perturbations et
   • un contrôleur (204) apte à déterminer ledit gain variable à partir de ladite deuxième différence.

2. Système d'amplification selon la revendication 1 comportant au moins un dispositif d'extraction (301), dudit signal amplifié, vers ledit premier dispositif de détermination, ledit dispositif d'extraction comprenant :

   • un coupleur directionnel (302) servant à récupérer le signal transmis sur un fil reliant ledit dispositif d'amplification et une antenne,
   • au moins un dispositif (303) de réglage du gain du signal récupéré,
   • un mélangeur (304) du signal dont le gain a été réglé avec un signal sinusoïdal,
   • et une pluralité de filtres (305) pour filtrer le signal mélangé, lesdits filtres comprenant au moins un filtre analogique à bande passante fixe servant d'anti-repliement et/ou d'antibrouillage et au moins un filtre numérique commutable à bande passante variable en fonction d'une bande passante dudit signal à amplifier et/ou d'un écart entre une fréquence dudit signal à amplifier et une fréquence desdites perturbations,

   de plus ledit troisième dispositif est adapté en outre pour la détermination d'un modèle de la perturbation de la première différence par ledit dispositif d'amplification et ledit dispositif d'extraction.

3. Système d'amplification selon la revendication 1 ou 2 dans lequel ledit premier dispositif de détermination (103) est relié directement audit modem (101).

4. Système d'amplification selon l'une des revendications 1 à 3 dans lequel ledit contrôleur (204) est un contrôleur PID.

5. Système d'amplification selon l'une des revendications 1 à 4 dans lequel ledit deuxième dispositif de détermination (104) comporte une table de conversion (501) mettant en relation une puissance dudit signal à émettre et ledit gain d'amplification.

6. Procédé d'utilisation du système d'amplification selon l'une des revendications 1 à 5 comportant les étapes successives suivantes :

    • une étape (601) de configuration du gain dudit dispositif d'amplification, ladite étape de configuration étant réalisée lorsque ledit signal à amplifier est de puissance nulle,
    • une étape (602) d'augmentation du gain d'amplification du dispositif d'amplification, lors d'une phase d'initialisation, durant laquelle ledit signal à amplifier ne comporte pas de données utiles,
    • une étape (604) de désactivation de la régulation du gain, ladite étape de désactivation étant réalisée lorsque le signal à amplifier comporte des données utiles.

7. Procédé selon la revendication 6 comportant en outre une étape (603) de régulation du gain d'amplification du dispositif d'amplification, ladite étape (603) de régulation du gain d'amplification étant effectuée après ladite étape (602) d'augmentation du gain d'amplification, de plus ladite étape de régulation (603) étant réalisée à partir d'une consigne.

8. Procédé selon la revendication 6 ou 7 dans lequel ladite étape de configuration (601) est adaptée pour la mise en oeuvre de la relation

$$Pout\_max = Pout\_mean\_consigne\_MODEM + Facteur\_crete\_modulation$$

où ;

    • $Pout\_max$ représente en dB la puissance de sortie maximum,
    • $Pout\_mean\_consigne\_MODEM$ représente en dB la puissance moyenne du signal que va émettre ledit modem (101) et
    • $Facteur\_crete\_modulation$ représente en dB le facteur de crête de la modulation du signal qui va être émis par ledit modem (101),

et dans lequel l'étape de configuration (601) est adaptée pour configurer ledit dispositif d'amplification (102) afin de pouvoir transmettre une puissance de sortie maximum de $Pout\_max$.

9. Procédé selon l'une des revendications 6 à 8 dans lequel ladite étape d'augmentation du gain d'amplification (602) est mise en oeuvre :

    - au moyen d'une table de conversion (501) mettant en relation une puissance dudit signal à émettre et ledit gain d'amplification lorsque la puissance dudit signal à amplifier est inférieure à un seuil ; et
    - au moyen dudit contrôleur (204) lorsque la puissance dudit signal à amplifier est supérieure audit seuil.

**Patentansprüche**

1. Verstärkungssystem, verbunden mit einem Modem (101), welches ein zu verstärkendes Signal abgibt, wobei das System Folgendes beinhaltet:

    • mindestens eine Verstärkungsvorrichtung (102), in der ein Verstärkungsgrad variabel ist,
    • mindestens eine erste Vorrichtung (103) zum Bestimmen einer ersten Differenz zwischen einem verstärkten Signal und dem zu verstärkenden Signal,
• mindestens eine zweite Vorrichtung (104) zum Bestimmen des variablen Verstärkungsgrades anhand des zu verstärkenden Signals, des verstärkten Signals und der ersten Differenz,

wobei das System **dadurch gekennzeichnet ist, dass** die zweite Vorrichtung Folgendes beinhaltet:

• mindestens eine dritte Vorrichtung (201) zum Bestimmen eines Modells einer Störung der ersten Differenz durch die Verstärkungsvorrichtung mit Hilfe einer Korrelation zwischen dem zu verstärkenden Signal und dem verstärkten Signal, wobei das Modell eine Verzögerung und einen Verstärkungsgrad beinhaltet,
• mindestens eine vierte Vorrichtung (202) zum Bestimmen von Störungen der ersten Differenz, hervorgerufen durch die Verstärkungsvorrichtung, anhand des Modells und des zu verstärkenden Signals,
• mindestens eine fünfte Vorrichtung (203) zum Bestimmen einer zweiten Differenz zwischen der ersten Differenz und den Störungen, und
• einen Kontroller (204), in der Lage, den variablen Verstärkungsgrad anhand der zweiten Differenz zu bestimmen.

2. Verstärkungssystem nach Anspruch 1, beinhaltend mindestens eine Vorrichtung (301) zum Extrahieren des verstärkten Signals zur ersten Bestimmungsvorrichtung, wobei die Extraktionsvorrichtung Folgendes beinhaltet:

• einen gerichteten Koppler (302) zum Abfangen des übertragenen Signals über einen Draht, der die Verstärkungsvorrichtung und eine Antenne verbindet,
• mindestens eine Vorrichtung (303) zum Einstellen des Verstärkungsgrades des abgefangenen Signals,
• einen Mischer (304) des Signals, dessen Verstärkungsgrad mit einem Sinussignal eingestellt wurde,
• eine Vielzahl von Filtern (305) zum Filtern des gemischten Signals, wobei die Filter mindestens einen Analogfilter mit einer festen Bandbreite beinhalten, welcher als Anti-Aliasing-Filter und/oder Anti-Scrambling-Filter dient und mindestens einen umschaltbaren, digitalen Filter mit variabler Bandbreite entsprechend einer Bandbreite des zu verstärkenden Signals und/oder einer Abweichung zwischen einer Frequenz des zu verstärkenden Signals und einer Frequenz der Störungen,

wobei zudem die dritte Vorrichtung zum Bestimmen eines Modells der Störung der ersten Differenz durch die Verstärkungsvorrichtung und die Extraktionsvorrichtung geeignet ist.

3. Verstärkungssystem nach Anspruch 1 oder 2, bei welchem die erste Bestimmungsvorrichtung (103) direkt mit dem Modem (101) verbunden ist.

4. Verstärkungssystem nach einem der Ansprüche 1 bis 3, bei welchem der Kontroller (204) ein PID-Kontroller ist.

5. Verstärkungssystem nach einem der Ansprüche 1 bis 4, bei welchem die zweite Bestimmungsvorrichtung (104) eine Umwandlungstabelle (501) beinhaltet, welche eine Leistung des zu sendenden Signals mit dem Verstärkungsgrad in ein Verhältnis setzt.

6. Verfahren zur Verwendung des Verstärkungssystems nach einem der Ansprüche 1 bis 5, beinhaltend folgende nacheinander folgenden Schritte:

• einen Schritt (601) des Konfigurierens des Verstärkungsgrades der Verstärkungsvorrichtung, wobei der Schritt des Konfigurierens erfolgt, wenn das zu verstärkende Signal eine Leistung gleich null besitzt,
• einen Schritt (602) des Erhöhens des Verstärkungsgrades der Verstärkungsvorrichtung, im Zuge einer Initialisierungsphase, in deren Verlauf das zu verstärkende Signal keine Nutzdaten beinhaltet,
• einen Schritt (604) des Deaktivierens der Verstärkungsgradregelung, wobei der Schritt des Deaktivierens erfolgt, wenn das zu verstärkende Signal Nutzdaten beinhaltet.

7. Verfahren nach Anspruch 6, zudem beinhaltend
einen Schritt (603) des Regelns des Verstärkungsgrades der Verstärkungsvorrichtung, wobei der Schritt (603) des Regelns des Verstärkungsgrades nach demjenigen Schritt (602) des Erhöhens des Verstärkungsgrades erfolgt, wobei zudem der Schritt des Regelns (603) anhand eines Sollwertes erfolgt.

8. Verfahren nach Anspruch 6 oder 7, bei welchem der Schritt des Konfigurierens (601) geeignet ist zur Umsetzung des Verhältnisses

$$Pout\_max$$

$$= Pout\_mean\_Sollwert\_MODEM$$

$$+ Faktor\_Peak\_Modulation$$

wobei:

- *Pout_max* die maximale Ausgangsleistung in dB darstellt,
- *Pout_mean_Sollwert_MODEM* die mittlere Leistung des Signals in dB darstellt, die vom Modem (101) gesendet wird; und
- *Faktor_Peak_Modulation* den Peak-Faktor der Signalmodulation in dB darstellt, die vom Modem (101) gesendet wird,

und wobei der Schritt des Konfigurierens (601) geeignet ist, um die Verstärkungsvorrichtung (102) zu konfigurieren, um eine maximale Ausgangsleistung von *Pout_max* zu übertragen.

9. Verfahren nach einem der Ansprüche 6 bis 8, bei welchem der Schritt des Erhöhens des Verstärkungsgrades (602) umgesetzt wird:

- mit Hilfe einer Umwandlungstabelle (501), welche eine Leistung des zu sendenden Signals und den Verstärkungsgrad in ein Verhältnis setzt, wenn die Leistung des zu verstärkenden Signals einen Schwellenwert unterschreitet; und
- mit Hilfe des Kontrollers (204), wenn die Leistung des zu verstärkenden Signals diesen Schwellenwert überschreitet.

**Claims**

1. An amplification system, connected to a modem (101) delivering a signal to be amplified, said system comprising:

- at least one amplification device (102) in which one amplification gain is variable,
- at least one first device (103) for determining a first difference between an amplified signal and said signal to be amplified,
- at least one second device (104) for determining said variable gain on the basis of said signal to be amplified, said amplified signal and said first difference;

said system being **characterised in that** said second device comprises:

- at least one third device (201) for determining a model of a perturbation of the first difference by the amplification device by means of a correlation between said signal to be amplified and said amplified signal, said model comprising a delay and a gain,
- at least one fourth device (202) for determining perturbations of the first difference that are caused by said amplification device, on the basis of said model and said signal to be amplified,
- at least one fifth device (203) for determining a second difference between said first difference and said perturbations, and
- a controller (204) that is capable of determining said variable gain on the basis of said second difference.

2. The amplification system according to Claim 1 comprising at least one extraction device (301) for extraction of said amplified signal to said first determination device, said extraction device comprising:

- a directional coupler (302) that is used to recover the signal transmitted on a wire connecting said amplification device and an antenna,
- at least one device (303) for regulation of the gain of the recovered signal,
- a mixer (304) for the signal that has had its gain regulated with a sinusoidal signal,
- and a plurality of filters (305) for filtering the mixed signal, said filters comprising at least one fixed-bandwidth analogue filter that is used for anti-aliasing and/or anti-jamming and at least one switchable digital filter with the bandwidth that varies as a function of a bandwidth of said signal to be amplified and/or of a disparity between a frequency of said signal to be amplified and a frequency of said perturbations,

moreover said third device is suited furthermore to the determination of a model of the perturbation of the first difference by said amplification device and said extraction device.

**3.** The amplification system according to Claim 1 or 2, wherein said first determination device (103) is connected directly to said modem (101).

**4.** The amplification system according to any of Claims 1 to 3, wherein said controller (204) is a PID controller.

**5.** The amplification system according to any of Claims 1 to 4, wherein said second determination device (104) comprises a conversion table (501) relating a power of said signal to be transmitted to said amplification gain.

**6.** A method for using the amplification system according to any of Claims 1 to 5, comprising the following successive steps:

• a step (601) of configuration of the gain of said amplification device, said step of configuration being carried out when said signal to be amplified has zero power,
• a step (602) of increase of the amplification gain of the amplification device, in an initialization phase, during which said signal to be amplified does not comprise any useful data,
• a step (604) of deactivation of the regulation of the gain, said step of deactivation being carried out when the signal to be amplified comprises useful data.

**7.** The method according to Claim 6, furthermore comprising
a step (603) of regulation of the amplification gain of the amplification device, said step (603) of regulation of the amplification gain being carried out after said step (602) of increase of the amplification gain, moreover said step of regulation (603) being carried out on the basis of a setpoint.

**8.** The method according to Claim 6 or 7, in which said step of configuration (601) is adapted to the implementation of the relationship

$$Pout\_max$$
$$=Pout\_mean\_MODEM\_setpoint$$
$$+Modulation\_crest\_factor$$

where;

• *Pout_max* represents the maximum output power in dB,
• *Pout_mean_MODEM_setpoint* represents the mean power in dB of the signal that said modem (101) will transmit and
• *Modulation_crest_factor* represents the modulation crest factor in dB of the signal that will be transmitted by said modem (101),

and in which the step of configuration (601) is adapted to configure said amplification device (102) so as to be able to transmit a maximum output power of *Pout_max.*

**9.** The method according to any of Claims 6 to 8, wherein said step of increase of the amplification gain (602) is implemented:

- by means of a conversion table (501) relating a power of said signal to be transmitted to said amplification gain when the power of said signal to be amplified is lower than a threshold; and
- by means of said controller (204) when the power of said signal to be amplified is higher than said threshold.

FIG.1

FIG.3

FIG.2

FIG.4a

FIG.4b

FIG.4c

Sig_in(n)

V_cmd(n) → $H_{WA}$ → $G_{WA}(n)$ → ⊗ → Sig_out(n)

# FIG.4d

101 — Modem → Signal à amplifier → Amplification gain variable — 102 → Signal amplifié

Détermination gain variable — 104

Table de conversion ou calibration — 501

Détermination première différence — 103

# FIG.5

FIG.6

FIG.7

Signal RF

Phase 1:
blanking

Phase 2:
shaping up

Phase 3:
dédiée ALC

Phase 4: données utiles

Temps

EP 2 863 541 B1

FIG.8

Module radio: chaîne d'émission

amplificateur

806a

807a

803a

mélangeur tx

DAC

DAC

DAC

ADC

805

803b

LUT

LUT

802

801b

806b

FPGA

X

Traitement numérique invention

Table de calibration

807

801a

Echantillons IQ

MODEM

804

## RÉFÉRENCES CITÉES DANS LA DESCRIPTION

**Documents brevets cités dans la description**

- US 20020171484 A1
- US 7058369 B1
- US 7023278 B1, Rockwell Collins
- US 6735420 B2, Globespan Virata
- US 7353006 B2
- US 7773691 B2